# EUROPÄISCHE PATENTSCHRIFT

(11) **EP 2 416 497 B1**
(45) Veröffentlichungstag und Bekanntmachung des Hinweises auf die Patenterteilung: **18.09.2013**
(21) Anmeldenummer: 11176094.8
(22) Anmeldetag: 01.08.2011
(51) Int. Cl.: H03K 17/00, H03K 17/76, H02J 1/10, H02J 7/34

(54) **Vorrichtung zur Kopplung eines Brennerlüfters an einen Mikroprozessor**
Device for coupling a burner ventilator to a microprocessor
Dispositif de couplage d'un brûleur à un microprocesseur

(30) Priorität: 05.08.2010 DE 102010033448
(43) Veröffentlichungstag der Anmeldung: 08.02.2012
(73) Patentinhaber: Honeywell Technologies Sarl, 1180 Rolle (CH)
(72) Erfinder: Vegter, Derk, 7833BH Nieuw-Amsterdam (NL)
(74) Vertreter: Sturm, Christoph

(56) Entgegenhaltungen:
- EP-A1- 0 269 767
- US-B1- 6 639 433

## Beschreibung

Die Erfindung betrifft eine Vorrichtung zur Kopplung eines Brennerlüfters an einen Mikroprozessor nach dem Oberbegriff des Anspruchs 1.

Aus der Praxis sind Gasbrenner bekannt, denen zur Verbrennung ein Gas-Verbrennungsluft-Gemisch zugeführt wird. Bei der Verbrennung des Gas-Verbrennungsluft-Gemisches im Gasbrenner entstehendes Abgas kann mithilfe eines Lüfters bzw. eines Gebläses vom Gasbrenner abgeleitet werden. Ein Lüfter bzw. ein Gebläse eines Gasbrenners wird auch als Brennerlüfter bezeichnet.

Aus der Praxis bekannte Brennerlüfter sind typischerweise als Gleichspannungs-Brennerlüfter ausgeführt, deren Drehzahl von einer Steuerungseinrichtung des Brennerlüfters gesteuert bzw. geregelt wird, vorzugsweise über eine pulsweitenmodulierte (PWM) Regelung bzw. Steuerung. Hierzu muss der Brennerlüfter, nämlich die Steuerungseinrichtung desselben, an einem Mikrokontroller bzw. Mikroprozessor gekoppelt werden, wobei hierzu eine Kopplungsvorrichtung dient, die Ober einen eingangsseitigen Anschluss für den Mikroprozessor und einen ausgangsseitigen Anschluss für den Brennerlüfter, nämlich die Steuerungseinrichtung desselben, verfügt.

Der Mikroprozessor stellt über die Kopplungsvorrichtung ein Steuersignal für die Steuerungseinrichtung des Brennerlüfters bereit, auf Basis dessen die Steuerungseinrichtung des Brennerlüfters den Betrieb desselben steuert bzw. regelt. Bei Brennerlüftern unterscheidet man grundsätzlich zwischen zwei Gruppen, nämlich einer ersten Gruppe, die über einen Spannungseingang verfügt, und eine zweite Gruppe, die über einen Stromeingang verfügt. Bei Brennerlüftern mit einem Spannungseingang wird als Steuersignal ein logisches Spannungssteuersignal benötigt. Bei Brennerlüftern, die über einen Stromeingang verfügen, wird als Steuersignal ein Stromsteuersignal benötigt. Nach der Praxis werden für diese unterschiedlichen Gruppen an Brennerlüftern unterschiedliche Kopplungsvorrichtungen bereitgehalten. Es werden demnach für Brennerlüfter mit einem Spannungseingang und für Brennerlüfter mit einem Stromeingang unterschiedliche Kopplungsvorrichtungen benötigt, um den Brennerlüfter an einem Mikroprozessor anzukoppeln. Dies ist von Nachteil.

Eine Vorrichtung nach dem Oberbegriff des Anspruchs 1 ist aus der EP 0 269 767 A1 bekannt.

Der Erfindung liegt die Aufgabe zu Grunde, eine neuartige Vorrichtung zur Kopplung eines Brennerlüfters an einen Mikroprozessor zu schaffen, die für unterschiedliche Brennerlüfterausführungen geeignet ist.

Diese Aufgabe wird durch eine Vorrichtung gemäß Anspruch 1 gelöst.

Die hier vorliegende Erfindung schlägt erstmals eine Kopplungsvorrichtung für einen Brennerlüfter vor, über weiche unterschiedliche Brennerlüfter an einen Mikroprozessor bzw. Mikrokontroller gekoppelt werden können.

So kann mit ein und derselben Kopplungsvorrichtung sowohl ein Brennerlüfter mit einem Spannungseingang, der zur Ansteuerung ein logisches Spannungssteuersignal benötigt, als auch ein Brennerlüfter mit einem Stromeingang, der zu Ansteuerung ein Stromsteuersignal benötigt, angeschlossen werden.

Die erfindungsgemäße Kopplungsvorrichtung stellt automatisch entweder ein logisches Spannungssteuersignal oder ein Stromsteuersignal für den Brennerlüfter bereit, nämlich abhängig davon, ob ein Brennerlüfter mit einem Spannungseingang oder einem Stromeingang an einen Ausgang der Kopplungsvorrichtung angeschlossen ist.

Nach einer vorteilhaften Weiterbildung der Erfindung umfasst die Vorrichtung einen zweiten Transistor, an dessen Basis der eingangsseitige Anschluss aufgeschaltet ist, an dessen Emitter der zweite Spannungsanschluss aufgeschaltet ist, und an dessen Kollektor die Reihenschaltung aus dem zweiten Widerstand und der oder jeder Diode angreift. Über die Verwendung des zweiten Transistors kann der Spannungs- bzw. Strombedarf der erfindungsgemäßen Kopplungsvorrichtung reduziert werden.

Bevorzugte Weiterbildungen der Erfindung ergeben sich aus den Unteransprüchen und der nachfolgenden Beschreibung. Nachfolgend werden Ausführungsbeispiele der Erfindung, ohne hierauf beschränkt zu sein, anhand der Zeichnung näher erläutert. In der Zeichnung zeigt:
- Fig. 1: ein schematisiertes Schaltbild einer ersten erfindungsgemäßen Vorrichtung zur Kopplung eines Brennerlüfters an einen Mikroprozessor;
- Fig. 2: ein schematisiertes Schaltbild einer zweiten erfindungsgemäßen Vorrichtung zur Kopplung eines Brennerlüfters an einen Mikroprozessor; und
- Fig. 3: ein schematisiertes Schaltbild einer dritten erfindungsgemäßen Vorrichtung zur Kopplung eines Brennerlüfters an einen Mikroprozessor.

Die Erfindung betrifft eine Vorrichtung zur Kopplung eines Brennerlüfters an einen Mikroprozessor. Eine solche Kopplungsvorrichtung dient insbesondere der Kopplung einer Steuerungseinrichtung eines Gleichstrom-Gasbrennerlüfters an einen Mikroprozessor bzw. Mikrokontroller, um über die Kopplungsvorrichtung ausgehend vom Mikroprozessor der Steuerungseinrichtung des Gasbrennerlüfters ein Ansteuersignal bereitzustellen, auf Grundlage dessen die Steuerungseinrichtung des Gasbrennerlüfters die Drehzahl desselben steuert bzw. regelt. Bei diesem Steuerungssignal handelt es sich vorzugsweise um ein PWM (pulsweitenmoduliertes) Steuerungssignal.

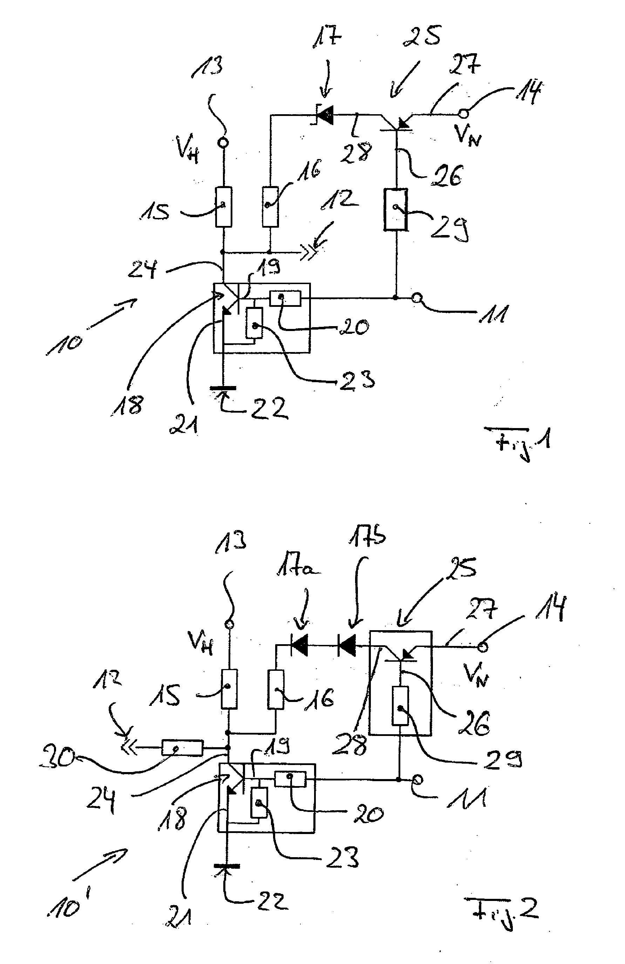

Fig. 1 visualisiert ein erstes Ausführungsbeispiel einer erfindungsgemäßen Kopplungsvorrichtung 10, wobei die Kopplungsvorrichtung der Fig. 1 einen eingangsseitigen Anschluss 11 aufweist, an welchem ein nicht gezeigter Mikroprozessor bzw. Mikrokontroller anschließbar ist, und wobei die Kopplungsvorrichtung 10 weiterhin einen ausgangsseitigen Anschluss 12 aufweist, an welchen ein Brennerlüfter mit einer Steuerungseinrichtung desselben anschließbar ist.

Gemäß Fig. 1 umfasst die Kopplungsvorrichtung 10 weiterhin einen ersten Spannungsanschluss 13, an welchem eine relativ hohe Spannung V_{H} anliegt, und einen zweiten Spannungsanschluss 14, an welchem eine relativ niedrige Spannung V_{N} anliegt. Der erste Spannungsanschluss 13, an welchem die relativ hohe Spannung V_{H} anliegt, ist unter Zwischenschaltung eines ersten Widerstands 15 an den ausgangsseitigen Anschluss 12 der Kopplungsvorrichtung 12 gekoppelt. Der zweite Spannungsanschluss 14, an welchem die relativ niedrige Spannung V_{N} anliegt, ist über eine Reihenschaltung aus einem zweiten Widerstand 16 und mindestens einer Diode 17 an den ausgangsseitigen Anschluss 12 gekoppelt.

Über den ersten Spannungsanschluss 13 und den ersten Widerstand 15 kann am ausgangsseitigen Anschluss 12 ein logisches Spannungssteuersignal für einen Brennerlüfter, nämlich eine Steuerungseinrichtung desselben bereitgestellt werden. Über den zweiten Spannungsanschluss 14 und die Reihenschaltung aus dem zweiten Widerstand 16 und der Diode 17 kann am ausgangsseitigen Anschluss 12 ein Stromsteuersignal für den Brennerlüfter, nämlich die Steuerungseinrichtung desselben, bereitgestellt werden. Dies erfolgt automatisch abhängig davon, ob am ausgangsseitigen Anschluss 12 der Kopplungsvorrichtung 10 ein Brennerlüfter mit einem Spannungseingang oder einem Stromeingang angeschlossen ist.

Dann, wenn am ausgangsseitigen Anschluss 12 der Kopplungsvorrichtung 10 ein Brennerlüfter mit einem Spannungseingang angeschlossen ist, sperrt die Diode 17 und es wird über den ersten Spannungsanschluss 13 und den ersten Widerstand 15 am Anschluss 12 ein logisches Spannungssteuersignal bereitgestellt. Dann hingegen, wenn am ausgangsseitigen Anschluss 12 der Kopplungsvorrichtung 10 ein Brennerlüfter mit einem Stromeingang angeschlossen ist, leitet die Diode 17 und es wird am Ausgang 12 ausgehend vom zweiten Spannungsanschluss 14 über die Diode 17 und den zweiten Widerstand 16 am Ausgang 12 ein Stromsteuersignal für den Brennerlüfter bereitgestellt.

Bei der relativ hohen Spannung V_{H}, die am ersten Spannungsanschluss 13 anliegt, kann es sich um eine Spannung von +24V handeln. Bei der relativ niedrigen Spannung V_{N}, die am zweiten Spannungsanschluss 14 anliegt, kann es sich zum Beispiel um +5V oder auch um +3,2V handeln.

Der mit dem ersten Spannungsanschluss 13 zusammenwirkende, erste elektrische Widerstand verfügt über einen relativ großen Widerstandswert in einer Größenordnung zwischen 10kΩ und 30kΩ, der mit dem zweiten Spannungsanschluss 14 zusammenwirkende, zweite elektrische Widerstand 16 verfügt hingegen über einen relativ kleinen Widerstandswert in einer Größenordnung zwischen 50Ω und 200Ω.

Fig. 1 kann entnommen werden, dass der erste Spannungsanschluss 13 mit dem ersten Widerstand 15 sowie der zweite Spannungsanschluss 14 mit der Reihenschaltung aus dem zweiten Widerstand 16 und der Diode 17 im Sinne einer Parallelschaltung an den ausgangsseitigen Anschluss 12 der Kopplungsvorrichtung 10 gekoppelt sind.

Gemäß Fig. 1 umfasst die erfindungsgemäße Kopplungsvorrichtung 10 weiterhin einen ersten Transistor 18, an dessen Basis 19 der eingangsseitige Anschluss 11 der Kopplungsvorrichtung 10 ausgeschaltet ist, gemäß Fig. 1 vorzugsweise unter Zwischenschaltung eines Widerstands 20. An einen Emitter 21 des ersten Transistors 18 ist ein Erdungsanschluss 22 aufgeschaltet, der Emitter 21 liegt demnach an Massepotential an. Gemäß Fig. 1 ist vorzugsweise zwischen die Basis 19 und den Emitter 21 des ersten Transistors 18 ein Widerstand 23 geschaltet. An einem Kollektor 24 des ersten Transistors 18 ist der ausgangsseitige Anschluss 12 der erfindungsgemäßen Kopplungsvorrichtung 10 aufgeschaltet, wobei an dem Kollektor 24 des ersten Transistors 18 auch die beiden Spannungsanschlüsse 13 und 14 aufgeschaltet sind, nämlich im Falle des Spannungsanschlusses 13 unter Zwischenschaltung des ersten Widerstands 15 und im Falle des Spannungsanschlusses 14 unter Zwischenschaltung der Reihenschaltung aus dem ersten Widerstand 18 und der Diode 17. Beim ersten Transistor 18 handelt es sich vorzugsweise um einen NPN-Transistor oder um einen N-MOS-Transistor.

Im Ausführungsbeispiel der Fig. 1 umfasst die erfindungsgemäße Kopplungsvorrichtung 10 weiterhin einen zweiten Transistor 25. An die Basis 26 des zweiten Transistors 25 ist der eingangsseitige Anschluss 11 der Kopplungsvorrichtung 10 aufgeschaltet. Dabei ist die Basis 26 des zweiten Transistors 25 über einen Widerstand 29 an den eingangsseitigen Anschluss 11 der Kopplungsvorrichtung 10 geschaltet.

An den Emitter 27 des zweiten Transistors 25 ist der zweite Spannungsanschluss 14 aufgeschaltet.

Am Kollektor 28 des zweiten Transistors 25 greift die Reihenschaltung aus dem zweiten Widerstand 16 und der Diode 17 an, nämlich derart, dass die Diode 17 mit ihrer Anode am Kollektor 28 des zweiten Transistors 25 angreift, wohingegen die Kathode der Diode 17 am zweiten Widerstand 16 angeschlossen ist.

Der zweite Transistor 25 ist vorzugsweise als PNP-Transistor oder P-MOS-Transistor ausgeführt und dient insbesondere der Reduzierung des Spannungsverbrauchs der Kopplungsvorrichtung 10.

Ein zweites Ausführungsbeispiel einer erfindungsgemäßen Kopplungsvorrichtung 10' zeigt Fig. 2, wobei die Kopplungsvorrichtung 10' der Fig. 2 hinsichtlich ihrer Funktionsweise der Kopplungsvorrichtung 10 der Fig. 1 entspricht, sodass zur Vermeidung unnötiger Wiederholungen für gleiche Baugruppen gleiche Bezugsziffern verwendet werden und nachfolgend nur auf solche Details eingegangen wird, durch die sich die Kopplungsvorrichtung 10' der Fig. 2 von der Kopplungsvorrichtung 10 der Fig. 1 unterscheidet.

Bei der Kopplungsvorrichtung 10' der Fig. 2 umfasst die Reihenschaltung aus dem ersten Widerstand 16 und mindestens einer Diode 17, die zwischen den Spannungsanschluss 14 und den ausgangsseitigen Anschluss 12 geschaltet ist, nicht wie im Ausführungsbeispiel der Fig. 1 eine einzige Diode 17, sondern vielmehr zwei hintereinander geschaltete Dioden 17a und 17b.

Die Diode 17b ist mit ihrer Anode an den Kollektor 28 des zweiten Transistors 25 geschaltet. Die Kathode der Diode 17b ist an die Anode der Diode 17a und die Kathode der Diode 17a an den zweiten Widerstand 16 angeschlossen.

Es sei darauf hingewiesen, dass auch mehr als zwei Dioden in Reihe geschaltet sein können, so zum Beispiel drei Dioden oder vier Dioden.

Nach einem weiteren Unterschied ist in Fig. 2 der ausgangsseitige Anschluss 12 der Kopplungsvorrichtung 10', an welchen die Steuerungseinrichtung eines Brennerlüfters anschließbar ist, über einen Widerstand 30 an den Kollektor des ersten Transistors 18 angeschlossen.

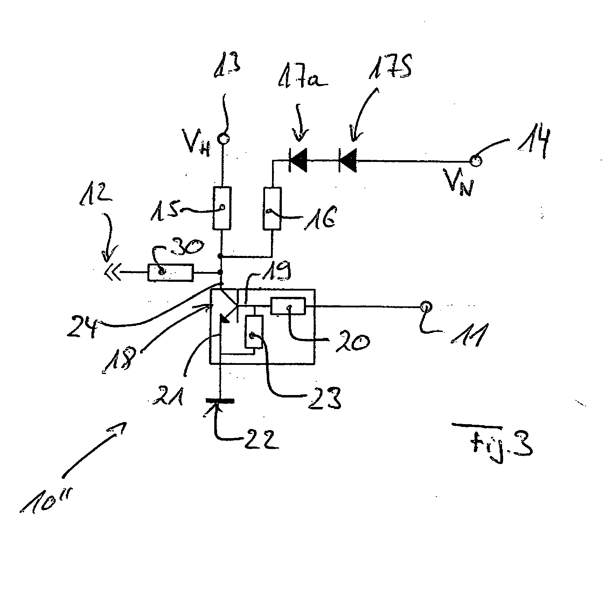

Im Ausführungsbeispiel der Fig. 3 ist eine Kopplungsvorrichtung 10" gezeigt, die der Kopplungsvorrichtung 10' der Fig. 2 entspricht, die jedoch keinen zweiten Transistor 25 aufweist.

Allen erfindungsgemäßen Kopplungsvorrichtungen 10, 10', 10" ist gemeinsam, dass mit denselben sowohl ein Brennerlüfter mit einem Stromeingang, der zur Ansteuerung ein logisches Spannungssteuersignal benötigt, als auch ein Brennerlüfter mit einem Stromeingang, der zur Ansteuerung ein Stromsteuersignal benötigt, mit einem Mikrokontroller bzw. Mikroprozessor gekoppelt werden kann, wobei die Kopplungsvorrichtung 10, 10' bzw. 10" automatisch abhängig vom angeschlossenen Brennerlüfter das entsprechende Steuersignal am Ausgang 12 bereitstellt. So müssen demnach für unterschiedliche Brennerlüfter keine unterschiedlichen Kopplungsvorrichtungen mehr bereitgehalten werden.

### Bezugszeichenliste

- 10, 10', 10": Kopplungsvorrichtung
- 11: eingangsseitiger Anschluss
- 12: ausgangsseitiger Anschluss
- 13: erster Spannungsanschluss
- 14: zweiter Spannungsanschluss
- 15: erster Widerstand
- 16: zweiter Widerstand
- 17, 17a, 17b: Diode
- 18: erster Transistor
- 19: Basis
- 20: Widerstand
- 21: Emitter
- 22: Erdungsanschluss
- 23: Widerstand
- 24: Kollektor
- 25: zweiter Transistor
- 26: Basis
- 27: Emitter
- 28: Kollektor
- 29: Widerstand
- 30: Widerstand

## Patentansprüche

1. Vorrichtung zur Kopplung eines Brennerlüfters, insbesondere einer Steuerungseinrichtung eines Gasbrennerlüfters, an einen Mikroprozessor, mit einem eingangsseitigen Anschluss, an welchen der Mikroprozessor anschließbar ist, und mit einem ausgangsseitigen Anschluss, an welchen der Brennerlüfter, insbesondere die Steuerungseinrichtung des Gasbrennerlüfters anschließbar ist, **gekennzeichnet durch**
einen ersten Spannungsanschluss (13), an welchem eine relative hohe Spannung zur Bereitstellung eines logischen Spannungssteuersignals für den Brennerlüfter anliegt, und einen zweiten Spannungsanschluss (14), an welchem eine relative niedrige Spannung zur Bereitstellung eines Stromsteuersignals für den Brennerlüfter anliegt, wobei der erste Spannungsanschluss (13) unter Zwischenschaltung eines ersten Widerstands (15) an den ausgangsseitigen Anschluss (12) gekoppelt ist, wobei der zweite Spannungsanschluss (14) unter Zwischenschaltung einer Reihenschaltung aus einem zweiten Widerstand (16) und mindestens einer Diode (17, 17a, 17b) an den ausgangsseitigen Anschluss (12) gekoppelt ist;
einen ersten Transistor (18), an dessen Basis (19) der eingangsseitige Anschluss (11) aufgeschaltet ist, an dessen Emitter (21) ein Erdungsanschluss (22) aufgeschaltet ist, und an dessen Kollektor (24) der ausgangsseitige Anschluss (12) aufgeschaltet ist.

2. Vorrichtung nach Anspruch 1, wobei der mit dem ersten Spannungsanschluss (13) zusammenwirkende erste Widerstand (15) einen relativ großen Widerstandswert der mit dem zweiten Spannungsanschluss (14) zusammenwirkende zweite Widerstand (16) einen relativ kleinen Widerstandswert aufweist.

3. Vorrichtung nach Anspruch 1 oder 2, wobei zwischen die Basis (19) des ersten Transistors (18) und den eingangsseitigen Anschluss (11) ein Widerstand (20) und zwischen die die Basis (19) des ersten Transistors (18) und den Emitter (21) desselben ein weiterer Widerstand (23) geschaltet ist.

4. Vorrichtung nach einem der Ansprüche 1 bis 3, wobei
zwischen den Kollektor (24) des ersten Transistors (18) und den ausgangsseitigen Anschluss (12) ein Widerstand (30) geschaltet ist.

5. Vorrichtung nach einem der Ansprüche 1 bis 4, wobei der erste Transistor (18) ein NPN-Transistor oder ein N-MOS-Transistor ist.

6. Vorrichtung nach einem der Ansprüche 1 bis 5, mit einem zweiten Transistor (25), an dessen Basis (26) der eingangsseitige Anschluss (11) aufgeschaltet ist, an dessen Emitter (27) der zweite Spannungsanschluss (14) aufgeschaltet ist und an dessen Kollektor (28) die Reihenschaltung aus dem zweiten Widerstand (16) und der oder jeder Diode (17, 17a, 17b) angreift.

7. Vorrichtung nach Anspruch 6, wobei am Kollektor (28) des zweiten Transistors (25) eine Anode einer Diode (17, 17b) der Reihenschaltung angreift.

8. Vorrichtung nach Anspruch 6 oder 7, wobei
zwischen die Basis (26) des zweiten Transistors (25) und den eingangsseitigen Anschluss (11) ein Widerstand (29) geschaltet ist.

9. Vorrichtung nach einem der Ansprüche 6 bis 8, wobei der zweite Transistor (25) ein PNP-Transistor oder ein P-MOS-Transistor ist.

## Claims

1. Device for coupling a burner fan, in particular a control device for a gas burner fan, to a microprocessor, with an input-side connection, to which the microprocessor can be connected, and with an output-side connection, to which the burner fan, in particular the control device of the gas burner fan, can be connected, **characterized by**
a first voltage connection (13), at which a relative high voltage is present for providing a logic voltage control signal for the burner fan, and a second voltage connection (14), at which a relative low voltage is present for providing a current control signal for the burner fan, wherein the first voltage connection (13) is coupled to the output-side connection (12) with a first resistor (15) interposed, wherein the second voltage connection (14) is coupled to the output-side connection (12) with a series circuit comprising a second resistor (16) and at least one diode (17, 17a, 17b) interposed, and
a first transistor (18), to whose base (19) the input-side connection (11) is connected, to whose emitter (21) a grounding connection (22) is connected, and to whose collector (24) the output-side connection (12) is connected.

2. Device according to Claim 1, wherein the first resistor (15), which interacts with the first voltage connection (13), has a relatively high resistance value, and the second resistor (16), which interacts with the second voltage connection (14) has a relatively low resistance value.

3. Device according to Claim 1 or 2, wherein a resistor (20) is connected between the base (19) of the first transistor (18) and the input-side connection (11), and a further resistor (23) is connected between the base (19) of the first transistor (18) and the emitter (21) thereof.

4. Device according to one of Claims 1 to 3, wherein a resistor (30) is connected between the collector (24) of the first transistor (18) and the output-side connection (12).

5. Device according to one of Claims 1 to 4, wherein the first transistor (18) is an NPN transistor or an N-MOS transistor.

6. Device according to one of Claims 1 to 5, comprising a second transistor (25), to whose base (26) the input-side connection (11) is connected, to whose emitter (27) the second voltage connection (14) is connected, and on whose collector (28) the series circuit comprising the second resistor (16) and the or each diode (17, 17a, 17b) acts.

7. Device according to Claim 6, wherein an anode of a diode (17, 17b) in the series circuit acts on the collector (28) of the second transistor (25).

8. Device according to Claim 6 or 7, wherein a resistor (29) is connected between the base (26) of the second transistor (25) and the input-side connection (11).

9. Device according to one of Claims 6 to 8, wherein the second transistor (25) is a PNP transistor or a P-MOS transistor.

## Revendications

1. Dispositif de couplage d'un ventilateur de brûleur, notamment d'un dispositif de commande d'un ventilateur de brûleur, à un microprocesseur, comportant une borne côté entrée à laquelle le microprocesseur peut être connecté, et une borne côté sortie à laquelle le ventilateur de brûleur, notamment le dispositif de commande du ventilateur de brûleur, peut être connecté, **caractérisé par**
une première borne de tension (13) à laquelle est appliquée une tension relativement élevée destinée à délivrer un signal de commande de tension logique pour le ventilateur de brûleur, et une seconde borne de tension (14) à laquelle est appliquée une tension relativement faible destinée à délivrer un signal de commande de courant pour le ventilateur de brûleur, la première borne de tension (13) étant couplée, avec interposition d'une première résistance (15), à la borne côté sortie (12), la seconde borne de tension (14) étant couplée, avec interposition d'un circuit série constitué d'une seconde résistance (16) et d'au moins une diode (17, 17a, 17b) à la borne côté sortie (12) ;
un premier transistor (18) à la base (19) duquel est connectée la borne côté entrée (11), à l'émetteur duquel (21) est connectée une borne de masse (22) et au collecteur duquel (24) est connectée la borne côté sortie (12).

2. Dispositif selon la revendication 1, dans lequel la première résistance (15) coopérant avec la première borne de tension (13) présente une valeur de résistance relativement élevée et la seconde résistance (16) coopérant avec la seconde borne de tension (14) présente une valeur de résistance relativement faible.

3. Dispositif selon la revendication 1 ou 2, dans lequel une résistance (20) est connectée entre la base (19) du premier transistor (18) et la borne côté entrée (11) et une autre résistance (23) est connectée entre la base (19) du premier transistor (18) et l'émetteur (21) de ce dernier.

4. Dispositif selon l'une quelconque des revendications 1 à 3, dans lequel une résistance (30) est connectée entre le collecteur (24) du premier transistor (18) et la borne côté sortie (12).

5. Dispositif selon l'une quelconque des revendications 1 à 4, dans lequel le premier transistor (18) est un transistor NPN ou un transistor N-MOS.

6. Dispositif selon l'une quelconque des revendications 1 à 5, comportant un second transistor (25) à la base (26) duquel est connectée la borne côté entrée (11), à l'émetteur (27) duquel est connectée la seconde borne de tension (14) et au collecteur (28) duquel est appliqué le circuit série constitué de la seconde résistance (16) et de la ou de chaque diode (17, 17a, 17b).

7. Dispositif selon la revendication 6, dans lequel une anode d'une diode (17, 17b) du circuit série est appliquée au collecteur (28) du second transistor (25).

8. Dispositif selon la revendication 6 ou 7, dans lequel une résistance (29) est connectée entre la base (26) du second transistor (25) et la borne côté entrée (11).

9. Dispositif selon l'une quelconque des revendications 6 à 8, dans lequel le second transistor (25) est un transistor PNP ou un transistor P-MOS.
